# FASCICULE DE BREVET EUROPEEN

(11) **EP 1 720 714 B1**
(45) Date de publication et mention de la délivrance du brevet: **19.11.2008**
(21) Numéro de dépôt: 05733185.2
(22) Date de dépôt: 02.03.2005
(51) Int. Cl.: B41N 1/00, B41N 1/08, B41N 1/14, G03F 1/00, G03F 5/00, G03F 7/00

(54) **PLAQUES OFFSET ALLEGEES, PREPARATION ET UTILISATION**
LEICHTE OFFSET-PLATTEN, IHRE HERSTELLUNG UND VERWENDUNG
LIGHTWEIGHT OFFSET PLATES, PREPARATION AND USE THEREOF

(30) Priorité: 03.03.2004 FR 0402174; 15.04.2004 FR 0403943
(43) Date de publication de la demande: 15.11.2006
(73) Titulaire: Nouel, Jean-Marie, 77760 Villiers sous Grez (FR)
(72) Inventeur: Nouel, Jean-Marie, 77760 Villiers sous Grez (FR)
(74) Mandataire: Le Roux, Martine
(86) Numéro de dépôt international: PCT/FR2005/000492
(87) Numéro de publication internationale: WO 2005/087505

(56) Documents cités:
- WO-A-20/04049694
- FR-A- 2 660 245
- FR-A- 2 722 584
- FR-A- 2 746 519
- FR-A- 2 752 958
- FR-A- 2 843 558

## Description

La présente invention se situe dans le contexte de l'offset humide et a plus précisément pour objet :
- des plaques, utiles à l'impression en offset humide, comportant à leur surface des surfaces encrophiles correspondant aux motifs à imprimer; au moins une partie desdites surfaces encrophiles étant allégées (i.e. renfermant de petites surfaces non encrophiles d'allégement) de façon originale;
- la préparation de telles plaques;
- leur utilisation dans le cadre de l'impression en offset humide.

L'utilisation des plaques de l'invention est particulièrement intéressante, car elle assure, à la surface desdites plaques, l'homogénéité du mélange encre-eau (base du procédé offset humide), et cela quel que soit le contexte exact de cette utilisation, à savoir : la nature du matériau à imprimer, de l'encre, de la machine d'impression, de la trame utilisées, l'importance et la répartition des surfaces encrophiles sur la plaque. Lesdites plaques assurent ainsi une excellente qualité d'impression. Leur utilisation entraîne par ailleurs une meilleure productivité, une diminution de la consommation de matières en général (encre, matériau à imprimer, plaque...) et facilite le séchage de l'encre déposée.

On sait que le procédé d'impression de l'offset humide utilise des supports (plaques) à la surface desquel(le)s ont été générées des surfaces encrophiles et aquaphobes, qui correspondent aux motifs à imprimer, pour prendre l'encre et la transférer et des surfaces non encrophiles et encrophobes pour refuser l'encre.

Sur la machine à imprimer, la plaque est tout d'abord mouillée par des rouleaux-mouilleurs (à moins que ne soit utilisée une encre de type "fluid ink", constituée d'un mélange encre/eau) et ensuite encrée par des rouleaux-encreurs. Lesdits rouleaux-encreurs déposent l'encre sur les surfaces encrophiles. Elle y est toujours mélangée à de l'eau, précédemment déposée par les rouleaux-mouilleurs ou de par sa constitution ("fluid ink"). Un blanchet, tissu ou métal recouvert d'une matière caoutchouteuse prend ensuite l'encre desdites surfaces encrophiles et la dépose sur le matériau à imprimer, par exemple du type papier, carton ou métal.

L'impression est réalisée en une ou plusieurs couleurs (le plus souvent avec des encres jaunes, magenta, cyan et/ou noires) sur des machines à imprimer de type machine-feuilles ou de type rotatives.

Quelle que soit la technique d'impression en cause, l'utilisation de l'encre et plus particulièrement son séchage reste à optimiser.

Les encres sont principalement constituées de pigments, d'huiles et d'adjuvants. On connaît, en référence à leur consistance, principalement trois types d'encre, avec lesquelles on vise à générer, à l'impression, des mélanges encre-eau homogènes et équilibrés sur les surfaces encrophiles de la plaque (de tels mélanges sont qualifiés d'homogènes ou d'équilibrés, s'ils conservent en leur sein la même quantité d'eau sur toutes les surfaces encrophiles de la plaque, quelles que soient l'importance et la répartition desdites surfaces) et donc à assurer, sans difficultés particulières, des impressions de qualité. On connaît :
- les encres fermes, concentrées et souvent brillantes, et/ou haute résistance (HT), utilisables en faible épaisseur ;
- les encres dites "douces", plus fluides et moins concentrées en pigments que lesdites encres fermes, utilisées généralement en épaisseur plus importante sur des matériaux type carton, papiers mats pour les livres, papiers journaux.
   On propose un type particulier d'encre dite "douce", des encres fluides ("fluid inks"). Il s'agit, comme indiqué précédemment, de mélanges encre/eau, pré-constitués. Ils renferment généralement environ 80 % d'encre et 20 % d'eau. Ils sont directement déposés, sans mouillage préalable, sur les surfaces encrophiles des plaques. Leur utilisation est intéressante. Dispensée de l'étape préalable de mouillage, l'impression est simplifiée, la durée des mises en route et la consommation de papier sont réduites. Les encres fluides sont généralement utilisées sur des papiers mats, pour les impressions de textes en particulier. Leur utilisation est généralement limitée à ces contextes car l'on reproche auxdites encres de se déposer également, inéluctablement, sur les surfaces hydrophiles de la plaque ;
- les encres classiques, qui constituent un compromis entre les encres fermes et les encres dites "douces".

L'épaisseur de l'encre à déposer, généralement entre 0,5 et 5 µm, dépend principalement de la nature du matériau sur lequel elle est déposée et du type de motifs à imprimer.

Les mélanges encre/eau à réaliser à la surface des plaques lors de l'impression renferment généralement de 4 à 30 % en poids d'eau, le plus souvent de 12 à 18 % en poids d'eau. Ils doivent être le plus équilibrés possible, quelles que soient l'importance et la répartition des surfaces encrophiles desdites plaques. Avec des encres fermes et classiques qui refusent plus ou moins l'eau, les surfaces encrophiles refusent ladite eau qui s'accumule sur les autres surfaces des plaques ; avec des encres dites "douces" qui ont tendance à se mélanger avec trop d'eau, on observe l'émulsification desdites encres ... La maîtrise du mélange encre/eau à la surface des plaques en cours d'impression est un réel problème technique et est souvent une des principales causes des soucis des imprimeurs.

Pour ce qui concerne le séchage desdites encres, sa mise en oeuvre est une opération délicate et/ou coûteuse.

Les techniques de séchage développées à ce jour sont principalement au nombre de quatre. Elles sont familières à l'homme du métier. Elles sont adaptées à la nature des encres en cause :
- séchage, par pénétration dans le support encré, pour les encres dites "coldset" ;
- séchage, par évaporation, pour les encres dites "heatset" ;
- séchage, par irradiation U.V., pour les encres dites U.V. ; et
- séchage, par oxydo-polymérisation, pour les encres dites "sheetfed".

La reproduction est par ailleurs faite entre deux valeurs, qui sont, d'une part, la valeur "zéro", c'est-à-dire la couleur du matériau à imprimer, vierge et, d'autre part, la valeur "maximale", c'est-à-dire l'aplat réalisé avec l'encre utilisée. Pour rendre les teintes intermédiaires, on utilise des trames :
- principalement, des trames classiques, à modulation d'amplitude : qui permettent d'obtenir des surfaces d'aplat plus ou moins importantes, suivant que lesdites teintes intermédiaires sont plus proches de l'aplat ou de la couleur du matériau. Suivant le procédé d'impression utilisé, la nature du matériau à imprimer et des documents à imprimer, on utilise des trames plus ou moins fines, telles que des trames 300, 200, 175, 150, 133, 120, 100, 80, 65, ce chiffre indiquant le nombre de linéature au pouce linéaire. Les points sont répartis suivant lesdites linéatures et ont différentes superficies suivant les valeurs à imprimer. Ils ont de plus leurs centres équidistants, quelle que soit leur superficie. Pour éviter tout moirage entre les couleurs, chaque couleur a des linéatures disposées suivant un angle différent, par exemple 45° pour le magenta, 15° pour le cyan, 75° pour le noir, 90° pour le jaune ;
- plus rarement, des trames stochastiques ou trames à modulation de fréquence : ces trames sont constituées de petits points, de même superficie, répartis de manière plus ou moins aléatoire. Les différentes valeurs sont représentées par une densité de points différente. La superficie des points d'une trame est choisie en fonction de la qualité du matériau à imprimer, du procédé d'impression et de l'encre utilisée. On préconise des points de 112 µm² à plus de 1 344 µm² pour des papiers mats et/ou bon marché (papier journal, par exemple). On a souvent apparition d'agglomérats, du fait de la coalescence de tels points.

Il est maintenant également proposé des trames, dites hybrides, composées d'une trame stochastique pour les teintes très claires et très foncées d'une trame classique pour les autres teintes.

De manière générale, les points des trames sont carrés ou plus ou moins ronds et/ou carrés, résultant d'un assemblage de pixels.

Le déposant, dans le contexte rappelé ci-dessus, a montré l'intérêt d'alléger l'impression, i.e. de créer de petites surfaces non encrophiles dans les surfaces encrophiles (petites surfaces non encrophiles qui se bouchent et se débouchent au cours de l'impression, de sorte qu'elles sont efficaces et améliorent ladite impression). Il a décrit ce principe de l'allégement dans la demande de brevet FR-A-2 660 245, il en a décrit un perfectionnement dans la demande de brevet EP-A-770 228. Selon ledit perfectionnement, les petites surfaces non encrophiles d'allégement sont réparties de manière aléatoire, suivant une (des) trame(s) stochastique(s). Il est préconisé de faire intervenir lesdites petites surfaces d'allégement à raison de 2 à 26 %, de préférence de 8 à 14 %, des surfaces encrophiles (ainsi allégées) et avec une superficie d'environ 400 µm². Il est toutefois prévu de telles petites surfaces non encrophiles de superficie bien moindre (196 µm², pour du très beau papier par exemple) ou de superficie bien plus importante (1 600 µm², pour du papier grossier type papier journal, par exemple).

L'utilisation de ces petites surfaces non encrophiles d'allégement procure de nombreux avantages, qui sont listés dans le texte de ladite demande EP-A-770 228, et notamment une meilleure homogénéité du mélange encre/eau. Ladite intervention s'est toutefois révélée ne pouvoir être développée que dans des limites certaines :
- la superficie des petites surfaces ne doit pas être trop petite car alors lesdites petites surfaces sont bouchées et restent bouchées par l'encre pendant toute l'impression et se révèlent donc inefficaces. Elle ne doit pas non plus être trop grande car alors lesdites petites surfaces sont visibles sur le support imprimé...
- le nombre desdites petites surfaces ne doit pas être trop faible pour que les améliorations escomptées se manifestent, ni trop important pour ne pas nuire à la reproduction des motifs, pour ne pas trop fragiliser les surfaces encrophiles, pour ne pas rendre trop délicat le réglage du mouillage...

Des essais ont confirmé que la superficie encrophile enlevée ne peut être augmentée, en vue de tirer encore plus avantage de l'allégement sans nuire à l'impression, en utilisant un très grand nombre de petites surfaces non encrophiles d'une superficie inférieure aux superficies des petites surfaces habituellement utilisées, ayant montrées leur efficacité. Les résultats sont décevants, lesdites petites surfaces, quels que soient le papier, la trame, l'encre, la machine utilisés et l'importance et la répartition des surfaces encrophiles sur la plaque, restent plus ou moins bouchées pendant toute l'impression.

Dans le cadre de la présente invention, on propose un allégement original qui permet d'alléger plus sans désavantage et au contraire, avec des avantages certains tant au niveau de la qualité de l'impression que de la mise en oeuvre de ladite impression (homogénéité du mélange encre-eau, quantités d'encre et de papier utilisées, séchage de l'encre...). Dans le cadre de la présente invention, on allège plus en faisant intervenir deux types de petites surfaces non encrophiles, en faisant collaborer deux types de petites surfaces non encrophiles : des petites surfaces non encrophiles efficaces *per se* et de plus petites surfaces non encrophiles efficaces de par la présence desdites petites surfaces non encrophiles efficaces *per se.*

Selon son premier objet, la présente invention concerne des plaques, utiles à l'impression en offset humide, comportant à leur surface des surfaces encrophiles correspondant aux motifs à imprimer ; au moins une partie desdites surfaces encrophiles étant allégée ; c'est-à-dire renfermant de petites surfaces non encrophiles d'allégement. Il s'agit de plaques, allégées au sens des documents de l'art antérieur : FR-A-2 660 245 et/ou EP-A-770 228 ; plaques positives ou négatives, prêtes à l'emploi, dont au moins une partie des surfaces encrophiles est criblée de milliers de petites surfaces non encrophiles d'allégement. On peut ainsi avoir toutes les surfaces encrophiles allégées ou seulement une partie d'entre elles...

De façon caractéristique, sur les plaques de ce type, on trouve selon l'invention, dans au moins une partie des surfaces encrophiles allégées, et avantageusement dans toutes lesdites surfaces encrophiles allégées, au moins deux groupes de petites surfaces non encrophiles d'allégement :
- un premier groupe de petites surfaces non encrophiles, de superficie(s) suffisante(s) pour être *per se* efficaces et en une quantité suffisante pour alléger d'au moins 4 % la (les) surfaces(s) encrophile(s) concernée(s) par l'allégement ; et
- un second groupe de petites surfaces non encrophiles, non efficaces *per se* de par leur(s) superficie(s) trop petite(s) ; la superficie moyenne desdites petites surfaces non encrophiles dudit second groupe étant en général inférieure aux 2/3 de la superficie moyenne desdites petites surfaces non encrophiles dudit premier groupe ;
lesdites petites surfaces non encrophiles desdits premier et second groupes étant distribuées de façon à minimiser, avantageusement éviter, tout moirage.

Les surfaces encrophiles allégées des plaques de l'invention peuvent l'être en partie de façon originale selon l'invention et en partie de façon classique selon FR-A-2 660 245 et/ou EP-A-770 228. Elles le sont avantageusement en totalité selon l'invention : elles renferment des petites surfaces non encrophiles du premier groupe et des petites surfaces non encrophiles du second groupe, dont l'effet (d'allégement) se cumule.

Les petites surfaces non encrophiles des premier et second groupes constituent en première analyse des surfaces d'allégement au sens de l'art antérieur. Leur intervention conjointe constitue la clef de la présente invention.

Dans le but de minimiser, voire d'éviter, tout moirage (effet de moiré), on préconise de faire intervenir lesdites petites surfaces d'allégement, distribuées :
- soit de manière aléatoire, selon des trames stochastiques ;
- soit de manière classique, selon des trames classiques (point blanc de 560 µm², proche du 98 % - trame 150, par exemple) mais alors, en les distribuant selon l'orientation utilisée pour la trame de la couleur à imprimer. L'homme de l'art sait que les linéatures de trames classiques sont orientées pour chaque couleur sous des angles différents (voir ci-dessus).

Il est prévu, dans le cadre de l'invention, de faire intervenir des petites surfaces d'allégement, à la surface d'une même plaque, selon différents types de distribution (trames stochastiques ou classiques), ceci par exemple selon la nature des petites surfaces en cause (du premier ou second groupe) et/ou les zones de ladite plaque en cause.

Dans un contexte d'impression (de motifs) avec une trame stochastique, les petites surfaces d'allégement des premier et second groupes sont avantageusement (en référence au problème du moirage) distribuées selon une (des) trame(s) classique(s). Elles sont (toujours en référence au problème du moirage) avantageusement orientées, pour chaque couleur, selon l'orientation normalement utilisée pour l'impression de ladite couleur.

Les petites surfaces non encrophiles du premier groupe sont efficaces en elles-mêmes de par leur superficie. Elles sont par ailleurs efficaces en ce qu'elles rendent efficaces les petites surfaces non encrophiles dudit second groupe, plus petites, de par leur quantité minimale d'intervention et ce, vraisemblablement en influant sur le mélange encre/eau, lors de l'impression.

Pour ce qui concerne la superficie desdites petites surfaces non encrophiles dudit premier groupe, on note tout d'abord qu'elle n'est pas forcément la même pour toutes lesdites petites surfaces non encrophiles dudit premier groupe. Selon une variante avantageuse, toutes lesdites petites surfaces ont la même superficie mais il ne s'agit que d'une variante. On peut tout à fait trouver sur une plaque de l'invention de petites surfaces non encrophiles efficaces *per se,* de superficies différentes. En tout état de cause, la (les) superficie(s) en cause est (sont) suffisante(s) pour réellement alléger l'impression (sans qu'il y ait bouchage systématique desdites petites surfaces, lors de l'utilisation de la plaque) mais restent bien évidemment de superficie raisonnable pour ne pas trop affecter l'impression.

L'homme du métier maîtrise parfaitement cette notion d'allégement efficace, non excessif, qui dépend de nombreux paramètres du procédé en cause. Dans le cadre de la présente invention, on préconise, de façon nullement limitative, que :
- pour une impression des motifs avec une trame à modulation d'amplitude, la (les) superficie(s) desdites petites surfaces non encrophiles dudit premier groupe demeure(nt) inférieure(s) au point blanc de la valeur 95 %, et avantageusement de la valeur 98 %, de ladite trame ; ou
- pour une impression des motifs avec une trame stochastique, la (les) superficie(s) desdites petites surfaces non encrophiles dudit premier groupe demeure(nt) inférieure(s) à 3 fois la superficie du point de ladite trame, est (sont) généralement comprise(s) entre 0,5 fois et 2 fois ladite superficie.

Pour une impression des motifs avec une trame à modulation d'amplitude, la (les) superficie(s) desdites petites surfaces non encrophiles dudit premier groupe est (sont) avantageusement inférieure(s) à la superficie des points blancs de trame, comprise entre 95 et 99,5 %, avantageusement entre 98 et 99,5 %, de la trame utilisée. Ainsi pour une trame souvent utilisée comme la trame 150, on préconise de telles petites surfaces non encrophiles d'une superficie comprise entre 336 µm² et 672 µm² (superficies des points blancs de trames, respectivement, d'environ 99,5 % et 97,7 %), de préférence de 448 µm² (superficie des points blancs d'une trame d'environ 98,5 %). Dans l'hypothèse où tous les points blancs des 98 % desdites petites surfaces non encrophiles se trouveraient sur des points encrophiles de valeur 2 % des motifs, ladite valeur 2 % serait amputée de x %, x représentant le taux d'allégement employé, par exemple 10 % (pour un taux d'allégement de 10 %, ladite valeur de 2 % deviendrait 2 - 0,2 = 1,98 %, ce qui ne serait pratiquement pas visible sur le matériau imprimé). L'homme du métier sait par ailleurs que le phénomène d'engraissement est apte à rendre non visible sur le matériau imprimé les points blancs de tout allégement raisonnable.

Les trames stochastiques à modulation de fréquence sont encore peu employées de nos jours. L'homme du métier en connaît les avantages (absence de rosette, très rare moirage entre les couleurs, excellente reproduction de nombreuses valeurs) et les inconvénients (difficiles réglages du mouillage et de l'encrage). Pour éviter, de manière générale et notamment dans le cadre de l'invention, une trop forte diminution des valeurs claires à l'impression, on peut prévoir de compenser ou de ne faire intervenir de petites surfaces non encrophiles d'allégement que dans les valeurs foncées. C'est en référence à cet allégement sélectif qu'il peut notamment être prévu des points d'allégement plus grands que les points de la trame employée ou plus petits dans les valeurs claires.

De toute manière, dans le cadre d'une impression des motifs avec une trame stochastique à modulation de fréquence, les petites surfaces non encrophiles d'allégement des deux groupes sont avantageusement disposées, si elles sont réalisées à partir d'une trame classique, en utilisant les linéatures orientées pour les différentes couleurs.

En tout état de cause, l'homme du métier est à même d'optimiser la (les) superficie(s) des petites surfaces non encrophiles d'allégement du premier groupe.

Ces petites surfaces, présentes dans la (les) surface(s) encrophile(s) allégée(s), assurent un taux d'allégement d'au moins 4%. On a compris que le taux d'allégement, ici 4 %, représente le rapport entre la superficie enlevée (la somme des superficies de toutes lesdites petites surfaces non encrophiles) et la superficie de la (les) surface(s) encrophile(s) d'où elle est enlevée. Ce taux d'allégement par les petites surfaces du premier groupe est généralement compris entre 4 et 20 %, avantageusement entre 6 et 12 %. Il doit être suffisant (≥ 4 %) pour rendre efficaces les petites surfaces non encrophiles du second groupe.

Ces petites surfaces non encrophiles du second groupe ne sont susceptibles de développer leur action d'allégement qu'en présence des petites surfaces non encrophiles du premier groupe ; ce, en référence à leur superficie. *Per se,* elles sont trop petites. Elles ne peuvent qu'être bouchées et restées bouchées dans les conditions normales d'utilisation. Par contre, utilisées avec les petites surfaces non encrophiles du premier groupe, elles deviennent actives et leur action (d'allégement) se cumule avec celle (d'allégement) desdites petites surfaces non encrophiles dudit premier groupe.

Ces petites surfaces non encrophiles du second groupe sont distribuées de manière aléatoire ou non. On a vu ci-dessus des méthodes pour minimiser voire éviter tout moirage.

Pour ce qui concerne la superficie desdites petites surfaces non encrophiles du second groupe, on note tout d'abord qu'elle n'est pas forcément la même pour toutes lesdites petites surfaces non encrophiles dudit second groupe. Selon une variante avantageuse, toutes lesdites petites surfaces non encrophiles dudit second groupe ont la même superficie mais il ne s'agit que d'une variante. On peut tout à fait trouver, sur une plaque de l'invention, de petites surfaces non encrophiles non efficaces *per se,* de superficies différentes. En tout état de cause, la (les) superficie(s) en cause est (sont) plus faible(s) que celle(s) des petites surfaces non encrophiles du premier groupe. Il est évidemment délicat d'indiquer des valeurs absolues, voire des valeurs relatives, au vu de tous les paramètres en cause. Il existe toutefois à la surface des plaques de l'invention, au sein des surfaces encrophiles, deux types de surfaces non encrophiles d'allégement : des petites, au sens classique du terme selon l'enseignement de FR-A-2 660 245 et/ou EP-A-770 228 et des plus petites. On peut indiquer que, de manière générale, la superficie moyenne des petites surfaces non encrophiles du second groupe est inférieure aux 2/3 de la superficie moyenne des petites surfaces non encrophiles du premier groupe. Selon une variante avantageuse, la superficie moyenne desdites petites surfaces non encrophiles dudit second groupe est comprise entre le 1/4 et les 2/3, avantageusement entre le 1/4 et la moitié, de la superficie moyenne desdites petites surfaces non encrophiles dudit premier groupe.

Lesdites petites surfaces non encrophiles du second groupe ne sauraient être trop petites car alors elles risquent de se révéler inefficaces, quelle(s) que soi(en)t la (les) superficie(s) des petites surfaces du premier groupe et quel que soit le contexte d'utilisation. Elles ont en principe une superficie supérieure à 100 µm². Par ailleurs, il se pose le problème de leur génération à la surface de la plaque.

Lesdites petites surfaces non encrophiles dudit second groupe interviennent avantageusement en une quantité suffisante pour alléger de 4 à 35 %, avantageusement de 8 à 20 %, la (les) surface(s) encrophiles(s) concernée(s) par l'allégement.

Les taux d'allégement résultant des petites surfaces non encrophiles desdits premier et second groupes se cumulent. Il s'est ainsi révélé possible, de façon tout à fait surprenante, d'alléger selon l'invention, de manière intéressante, à des taux qui selon l'art antérieur (avec un nombre plus important de petites surfaces du premier groupe et/ou avec de petites surfaces dudit premier groupe de superficie plus importante) sont très dommageables à l'impression...

Cela est d'autant plus possible que l'on peut utiliser des points d'allègement plus nombreux et/ou de superficies plus grandes du premier groupe dans certaines valeurs comme les valeurs très foncées et les aplats et utiliser moins nombreuses et/ou plus petites les petites superficies du second groupe dans certaines valeurs, comme les valeurs claires et très claires.

On rappelle incidemment ici que le taux d'allégement des surfaces encrophiles des plaques de l'invention n'est pas forcément constant ; le taux d'allégement dû aux petites surfaces non encrophiles du premier groupe et/ou le taux d'allégement dû aux petites surfaces non encrophiles du second groupe n'étant pas forcément constant. On connaît l'intérêt à alléger plus les valeurs foncées. Par ailleurs, l'emploi des petites surfaces non encrophiles du second groupe permet d'alléger les valeurs claires tout en évitant le "banding" (apparition de bandes), lorsque les petites surfaces d'allégement du premier groupe ne sont utilisées que dans les autres valeurs..

De façon caractéristique, on trouve donc à la surface des plaques de l'invention, plus précisément dans les surfaces encrophiles allégées de ladite surface (dans seulement une partie d'entre elles, et avantageusement dans toutes lesdites surfaces encrophiles allégées), des petites surfaces non encrophiles du premier groupe et des petites surfaces non encrophiles du second groupe. Si aucune précaution n'est prise, on trouve également, inéluctablement, des petites surfaces résultant de la superposition partielle d'une petite surface non encrophile du premier groupe et d'une petite surface non encrophile du second groupe, voire de l'accolage parfait (tangentiel) de deux telles petites surfaces. Cela risquant de nuire à l'impression, en générant des surfaces d'allégement trop importantes, susceptibles d'être visibles sur le support imprimé, on peut veiller à ce qu'aucune desdites petites surfaces non encrophiles du second groupe ne soit au contact (tangentiel et/ou avec superposition) d'une petite surface non encrophile du premier groupe. Les précautions sont à prendre au niveau de la préparation de la plaque. On peut ainsi utiliser un logiciel, générant toutes lesdites petites surfaces du second groupe séparées d'au moins un pixel desdites petites surfaces du premier groupe. Selon une variante avantageuse, dans les surfaces encrophiles allégées des plaques de l'invention, aucune desdites petites surfaces non encrophiles dudit second groupe n'est donc au contact d'une petite surface non encrophile dudit premier groupe.

Selon une autre variante avantageuse, chacune desdites petites surfaces non encrophiles desdits premier et second groupes est à l'intérieur de la surface encrophile au sein de laquelle elle intervient.

On a indiqué précédemment que toutes lesdites petites surfaces non encrophiles dudit premier groupe ont avantageusement la même superficie (notée, par exemple : S) et qu'indépendamment toutes lesdites petites surfaces non encrophiles dudit second groupe ont avantageusement la même superficie (notée, par exemple : s). Très avantageusement, les plaques de l'invention présentent deux groupes principaux de petites surfaces non encrophiles : un premier groupe, de superficie S et un second groupe, de superficie s ; (avec, accessoirement de petites surfaces non encrophiles dont la superficie est supérieure à S et vaut au maximum S + s).

Les plaques de l'invention, telles que décrites ci-dessus peuvent être obtenues par divers types de procédés, connus en eux-mêmes. On connaît lesdits procédés pour générer de petites surfaces d'allégement ; on préconise, selon l'invention, de les mettre en oeuvre pour générer au moins deux types de petites surfaces de ce type.

On peut procéder, de façon classique, (voir les demandes FR-A-2 660 245 et EP-A-770 228), par insolation de la plaque au travers d'au moins un film.

On peut procéder, comme enseigné dans la demande WO-A-97 35233, par insolation d'une bande présensibilisée positive, insolation au travers de la surface opaque et percée d'un tube ; ladite bande étant ensuite découpée en plaques.

On peut encore procéder par insolation directe (avec des imageuses ("computers")) avec des rayons pilotés par logiciel(s). Un même logiciel peut permettre l'obtention des surfaces encrophiles correspondant aux motifs à imprimer et des différents groupes de petites surfaces non encrophiles d'allégement. On peut également utiliser plusieurs logiciels... Toutes les variantes sont possibles. Des logiciels performants existent à ce jour.

On peut également procéder par une toute autre technique, une technique de projection. Avec des gicleurs, on projette soit la solution encrophile sur la plaque, soit une solution apte à éliminer des surfaces et petites surfaces du vernis encrophile précédemment déposé sur la plaque. Cette dernière variante de la technique de projection est décrite dans la demande FR-A-2 843 558.

On doit admettre que les procédés de préparation des plaques de l'invention sont des procédés par analogie, d'une mise en oeuvre de plus en plus aisée au vu des progrès de l'informatique.

La clé de l'invention - l'utilisation conjointe de groupes de surfaces non encrophiles différentes pour alléger des surfaces encrophiles - est elle totalement innovante et a des résultats intéressants inattendus. On revient sur ceux-ci un peu plus loin dans le présent texte.

Selon son dernier objet, la présente invention concerne un procédé d'impression en offset humide. Ledit procédé est un procédé classique, en ce qu'il comprend les étapes successives :
- de copie d'une plaque, générant à la surface de ladite plaque des surfaces encrophiles, correspondant aux motifs à imprimer et renfermant de petites surfaces non encrophiles d'allégement ;
- de fixation de ladite plaque copiée à un cylindre porte-plaque ;
- de mouillage puis d'encrage de ladite plaque copiée fixée ou directement son encrage avec une encre à base d'un mélange encre/eau ; et
- de transfert de l'encre retenue sur lesdites surfaces encrophiles sur, successivement, le blanchet puis le matériau à imprimer.

Il s'agit d'un procédé selon les demandes FR-A-2 660 245 et EP-A-770 228 en ce que la copie de la plaque comprend l'introduction de petites surfaces non encrophiles d'allégement dans les surfaces encrophiles.

Il s'agit d'un procédé original selon l'invention en ce que la plaque allégée est une plaque telle que décrite ci-dessus. De façon caractéristique, l'étape de copie comprend la création des deux groupes de petites surfaces non encrophiles dans les surfaces encrophiles.

L'intérêt de la présente invention est rappelé ci-après.

L'allégement amélioré au sens de l'invention s'est avéré efficace sur pratiquement tous les papiers, avec toutes les machines, les trames, les encres et quelles que soient l'importance et la répartition des surfaces encrophiles sur la plaque.

Ledit allégement amélioré procure les avantages de l'allégement (tels que notamment listés dans EP-A-770 228) améliorés. On insiste tout particulièrement sur l'excellence de la qualité d'impression, sur la meilleure productivité, sur les économies de matières et d'énergie.

La consommation d'encre et de papier est notamment réduite.

Le séchage de l'encre déposée est amélioré (notamment du fait de la meilleure homogénéité du mélange encre/eau et de la plus faible épaisseur dudit mélange déposé).

La qualité de l'impression est améliorée et cela d'autant plus qu'elle est mise en oeuvre dans des conditions moyennes, voire mauvaises.

De plus, l'allégement spécifique de l'invention ne "fragilise pas vraiment" les plaques. En effet, on peut estimer qu'en rendant plus équilibré le mélange encre-eau à la surface desdites plaques et donc en diminuant parallèlement le tirant de l'encre ("tack"), on augmente de plus de 60 % la longévité desdites plaques. Lesdites plaques n'ont plus à être soumises à des contraintes aussi sévères que celles de l'art antérieur (les dépôts sur les blanchets en grande partie responsables de l'usure des plaques ayant également été très diminués)...

Enfin, les plaques de l'invention permettent d'utiliser plus industriellement les encres fluides ("fluid ink").

L'invention est illustrée, de manière nullement limitative, par les exemples ci-après.

Les plaques utilisées dans les exemples 1 à 6 sont des plaques positives thermiques Thermostar 830 nm d'Agfa :
- 785 x 1030 x 30/100 pour une machine-feuilles Roland ;
- 708 x 1020 x 30/100, coupées ensuite au milieu (soit 708 x 510 x 30/100), pour une rotative Heidelberg Web 8.

Les plaques sont insolées avec les faisceaux d'une imageuse Xcalibur G.L.V., Print Drive, Double Burn, d'Agfa, développées, rincées, gommées puis séchées. Les trames stochastiques sont de la société Esko-Graphics, les encres de la société Sun Chemical.

### Exemple 1

On copie une plaque à l'aide de deux logiciels.

Le premier crée d'une part des petites surfaces non encrophiles d'allègement d'environ 896 µm², dont le nombre représente environ 6 % de la superficie encrophile de la plaque et d'autre part d'autres petites surfaces non encrophiles d'allègement d'environ 448 µm² et représentant 12 % de la même surface encrophile.

Toutes ces petites surfaces non encrophiles d'allègement sont réparties avec la technique aléatoire à modulation de fréquence et ne se touchent pas.

La surface encrophile est ainsi allégée de 6 % + 12 %, soit 18 %.

Le deuxième logiciel crée des textes et une reproduction en trame 100 avec le point blanc 98 % d'une superficie d'environ 1 290µm².

La plaque est fixée sur une rotative avec sécheur et l'impression est réalisée sans mouillage sur un papier mat avec de l'encre "fluid ink" (Washington Post Single Fluid Black) de Sun Chemical et qui contient en poids environ 20 % d'eau.

L'impression est bonne et 3 000 feuilles sont imprimées sans difficultés particulières, avec au démarrage une quantité de papier gâché limitée à quelques feuilles.

### Exemple 2

On procède comme dans l'exemple 1, mais en utilisant le mouillage de la machine et de l'encre dite "douce" (Solar^{®} de Sun Chemical).

L'impression est bonne, mais il est utilisé plus de papier en raison du réglage nécessaire du mouillage.

### Exemple 2bis

On procède comme dans l'exemple 2, mais les 18 % d'allègement sont réalisés avec seulement des petites surfaces non encrophiles de 896 µm².

Les réglages du mouillage sont plus délicats et la qualité de l'impression est moins bonne.

### Exemple 3

On copie une plaque avec un logiciel pour générer à sa surface d'une part des petites surfaces non encrophiles d'allégement d'environ 672 µm² (superficie supérieure à la superficie d'environ 573 µm² d'un point blanc de trame 98 % en trame 150), et représentant par leur nombre environ 8 % de la surface encrophile et d'autre part d'autres petites surfaces non encrophiles d'allègement d'environ 336 µm² et représentant par leur nombre environ 8 % de la même surface encrophile.

Réparties selon la technique aléatoire à modulation de fréquence, elles ne se touchent pas et elles représentent une superficie totale de 8 % + 8 % soit 16 %.

En utilisant la technique "double burn", un autre logiciel avec les textes et les reproductions en trame 150 est copié sur la plaque.

La plaque copiée recto-verso est coupée au milieu et la plaque recto et la plaque verso sont fixées sur la rotative.

L'encre utilisée est une encre ferme (Maury LWC^{®} de Sun Chemical).

L'impression est d'une grande qualité et le papier quitte facilement les blanchets en raison de la diminution du tirant de l'encre ("tack").

Mais, le débit des encriers n'a pu être réglé à un débit inférieur.

### Exemple 3bis

On procède comme dans l'exemple 3 mais avec un allégement de 16 % obtenu seulement avec les petites surfaces de 672 µm².

A l'impression, les reproductions tramées sont d'une qualité inférieure et le débit des encriers a du être augmenté pour obtenir les valeurs des épreuves du client.

### Exemple 4

Un logiciel génère d'une part de petites surfaces non encrophiles d'allégement d'environ 560 µm² (superficie proche de 573 µm² d'un point blanc 98 % en trame 150), et dont le nombre représente environ 8 % de la surface encrophile de la plaque ; et d'autre part de plus petites surfaces non encrophiles d'allégement d'environ 224 µm², et qui représentent environ 8 % de la même surface encrophile.

Lesdites petites surfaces sont toutes réparties suivant la technique aléatoire à modulation de fréquence et ne se touchent pas.

La superficie ainsi allégée est de 8 % + 8 %, soit 16 %.

Un autre logiciel représentant des textes et des reproductions tramées (trame 150) est copié en "double burn" avec le logiciel d'allègement.

L'encre utilisée est une encre ferme (Maury LWC^{®} de Sun Chemical).

Sur la rotative, l'impression est d'une grande qualité, le papier quitte facilement le blanchet, en raison de la diminution du tirant de l'encre ("tack"), le débit des encriers est réduit de manière significative, ce qui facilite aussi le séchage.

### Exemple 5

Un logiciel, ayant des textes et des reproductions en noir (une seule couleur) faites avec une trame à modulation de fréquence (stochastique) Monet de la société Esko-Graphics avec des points d'environ 672 µm² de superficie, est utilisé pour les reproductions. Il est copié en même temps (double-burn) qu'un autre logiciel d'allègement.

Celui-ci contient des petites surfaces non encrophiles d'allègement, ayant d'une part une superficie de 448 µm² et représentant par leur nombre 6 % de la surface encrophile et ayant d'autre part une superficie de 224 µm² représentant par leur nombre 8 % de la même surface encrophile, soit 6 % + 8 % = 14 % de surface encrophile allégée.

Toutes les petites surfaces non encrophiles d'allègement sont réparties suivant la technique aléatoire à modulation de fréquence et ne se touchent pas.

Les agglomérats de cette trame stochastique sont ainsi percés par les petites surfaces d'allègement et l'impression est d'une excellente qualité, sans connaître les difficultés souvent rencontrées sur la machine avec les trames stochastiques.

### Exemple 6

On utilise le même logiciel pour les textes et les reproductions en noir que dans l'exemple 5.

Mais l'allègement est effectué, d'une part avec 6 % de petites surfaces non encrophiles de 448 µm² de superficie et d'autre part 8 % de petites surfaces non encrophiles de 224 µm² de superficie.

Toutes les petites surfaces d'allègement sont utilisées suivant une linéature comparable à la linéature d'une trame classique, ne se touchent pas et sont placées suivant une orientation de 45°.

Les résultats sont comparables aux résultats de l'exemple 5.

## Revendications

1. Plaque, utile à l'impression en offset humide, comportant à sa surface des surfaces encrophiles correspondant aux motifs à imprimer ; au moins une partie desdites surfaces encrophiles étant allégée ; i.e. renfermant de petites surfaces non encrophiles d'allégement, **caractérisée en ce que** lesdites petites surfaces non encrophiles d'allégement, dans au moins une partie desdites surfaces encrophiles allégées, se répartissent en au moins deux groupes :
- un premier groupe de petites surfaces non encrophiles, de superficie(s) suffisante(s) pour être *per se* efficaces et en une quantité suffisante pour alléger d'au moins 4 % la (les) surface(s) encrophile(s) concernée(s) par l'allégement ; et
- un second groupe de petites surfaces non encrophiles, non efficaces *per se* de par leur(s) superficie(s) trop petite(s) ; la superficie moyenne desdites petites surfaces non encrophiles dudit second groupe étant en général inférieure aux 2/3 de la superficie moyenne desdites petites surfaces non encrophiles dudit premier groupe ;
lesdites petites surfaces non encrophiles desdits premier et second groupes étant distribuées de façon à minimiser, avantageusement éviter, tout moirage.

2. Plaque selon la revendication 1, **caractérisée en ce que** lesdites petites surfaces non encrophiles desdits premier et/ou second groupes sont distribuées de manière aléatoire ou selon des trames classiques et alors, pour chaque couleur, selon l'orientation utilisée pour la trame de ladite couleur.

3. Plaque selon la revendication 1 ou 2, **caractérisée en ce que**, pour une impression des motifs avec une trame stochastique, les petites surfaces non encrophiles desdits premier et second groupes, distribuées selon une (des) trame(s) classique(s), sont orientées, pour chaque couleur, selon l'orientation normalement utilisée pour l'impression de ladite couleur.

4. Plaque selon l'une quelconque des revendications 1 à 3,
**caractérisée en ce que** la superficie moyenne desdites petites surfaces non encrophiles dudit second groupe est comprise entre le 1/4 et les 2/3, avantageusement entre le 1/4 et la moitié, de la superficie moyenne desdites petites surfaces non encrophiles dudit premier groupe.

5. Plaque selon l'une quelconque des revendications 1 à 4,
**caractérisée en ce que** :
- pour une impression des motifs avec une trame à modulation d'amplitude, la (les) superficie(s) desdites petites surfaces non encrophiles dudit premier groupe demeure(nt) inférieure(s) au point blanc de la valeur 95 %, et avantageusement de la valeur 98 %, de ladite trame ; ou
- pour une impression des motifs avec une trame stochastique, la (les) superficie(s) desdites petites surfaces non encrophiles dudit premier groupe demeure(nt) inférieure(s) à 3 fois la superficie du point de ladite trame, est (sont) généralement comprise(s) entre 0,5 fois et 2 fois ladite superficie.

6. Plaque selon l'une quelconque des revendications 1 à 5,
**caractérisée en ce que** lesdites petites surfaces non encrophiles dudit premier groupe interviennent en une quantité suffisante pour alléger de 4 à 20 %, avantageusement de 6 à 12 %, la (les) surface(s) encrophile(s) concernée(s) par l'allégement.

7. Plaque selon l'une quelconque des revendications 1 à 6,
**caractérisée en ce que** lesdites petites surfaces non encrophiles dudit second groupe interviennent en une quantité suffisante pour alléger de 4 à 35 %, avantageusement de 8 à 20 %, la (les) surface(s) encrophile(s) concernée(s) par l'allégement.

8. Plaque selon l'une quelconque des revendications 1 à 7,
**caractérisée en ce que** le taux d'allégement de ses surfaces encrophiles n'est pas constant.

9. Plaque selon l'une quelconque des revendications 1 à 8,
**caractérisée en ce qu'**aucune desdites petites surfaces non encrophiles dudit second groupe n'est au contact d'une petite surface non encrophile dudit premier groupe.

10. Plaque selon l'une quelconque des revendications 1 à 9,
**caractérisée en ce que** chacune desdites petites surfaces non encrophiles desdits premier et second groupes est à l'intérieur de la surface encrophile au sein de laquelle elle intervient.

11. Plaque selon l'une quelconque des revendications 1 à 10,
**caractérisée en ce que** lesdites petites surfaces non encrophiles dudit premier groupe ont la même superficie et/ou, avantageusement et, lesdites petites surfaces non encrophiles dudit second groupe ont la même superficie.

12. Procédé pour la préparation d'une plaque selon l'une quelconque des revendications 1 à 11, **caractérisé en ce qu'**il comprend la copie de ladite plaque pour générer à la surface de ladite plaque les surfaces encrophiles correspondant aux motifs à imprimer ainsi que lesdites petites surfaces non encrophiles d'allégement au sein desdites surfaces encrophiles ; lesdites petites surfaces non encrophiles d'allégement étant copiées :
- par une technique d'insolation de ladite plaque au travers d'au moins un film et/ou une technique d'insolation d'une bande précurseur de plaques présensibilisées positives au travers de la paroi opaque d'un tube, et/ou
- par une technique d'insolation directe de ladite plaque avec des rayons pilotés par des logiciels ; et/ou
- par une technique de projection.

13. Procédé d'impression en offset humide, comprenant :
- la copie d'une plaque, générant à la surface de ladite plaque des surfaces encrophiles, correspondant aux motifs à imprimer et renfermant de petites surfaces non encrophiles d'allégement ;
- la fixation de ladite plaque copiée à un cylindre porte-plaque ;
- le mouillage puis l'encrage de ladite plaque copiée fixée ou directement son encrage avec une encre à base d'un mélange encre/eau ;
- le transfert de l'encre retenue sur lesdites surfaces encrophiles allégées sur, successivement, le blanchet puis le matériau à imprimer ;
**caractérisé en ce que** la copie de ladite plaque génère une plaque selon l'une quelconque des revendications 1 à 11.

## Claims

1. A plate useful in wet offset printing, comprising at its surface ink-accepting surfaces corresponding to patterns to be printed; at least part of said ink-accepting surfaces being lightened, *i.e,* including small non ink-accepting lightening surfaces, **characterized in that** over at least part of said lightened ink-accepting surfaces, said small non ink-accepting lightening surfaces are distributed in at least two groups:
a first group of small non ink-accepting surfaces with an area (areas) sufficient to be effective *per se* and in a quantity sufficient to lighten the ink-accepting surface(s) involved in lightening by at least 4%; and
a second group of small non ink-accepting surfaces, not effective *per se* because their area(s) is (are) too small ; the mean area of said small non ink-accepting surfaces of said second group in general being less than 2/3 of the mean area of said small non ink-accepting surfaces of said first group;
said small non ink-accepting surfaces of said first and second groups being distributed so as to minimize, advantageously avoid, any moiré effects.

2. The plate according to claim 1, **characterized in that** said small non ink-accepting surfaces of said first and/or second groups are distributed in a random manner or in conventional screens and then, for each color, in the orientation employed for the screen for said color.

3. The plate according to claim 1 or claim 2, **characterized in that** when printing patterns with a stochastic screen, the small non ink-accepting surfaces of said first and second groups distributed in a (several) conventional screen(s) are orientated for each color in the orientation normally used for printing said color.

4. The plate according to any one of claims 1 to 3, **characterized in that** the mean area of said small non ink-accepting surfaces of said second group is in the range 1/4 to 2/3, advantageously in the range 1/4 to 1/2 of the mean area of said small non ink-accepting surfaces of said first group.

5. The plate according to any one of claims 1 to 4, **characterized in that**:
· when printing patterns with an amplitude modulation screen, the area(s) of said small non ink-accepting surfaces of said first group remains (remain) smaller than the 95% white dot value, and advantageously smaller than the 98% white dot value of said screen; or
· when printing patterns with a stochastic screen, the area(s) of said small non ink-accepting surfaces of said first group is (are) always less than three times the area of the dot of said screen, and generally in the range 0.5 times to 2 times said area.

6. The plate according to any one of claims 1 to 5, **characterized in that** said small non ink-accepting surfaces of said first group are present in a quantity sufficient to lighten the ink-accepting surface(s) concerned with lightening by 4% to 20%, advantageously by 6% to 12%.

7. The plate according to any one of claims 1 to 6, **characterized in that** said small non ink-accepting surfaces of said second group are present in a quantity sufficient to lighten the ink-accepting surface(s) concerned with lightening by 4% to 35%, advantageously by 8% to 20%.

8. The plate according to any one of claims 1 to 7, **characterized in that** the percentage lightening of its ink-accepting surfaces is not constant.

9. The plate according to any one of claims 1 to 8, **characterized in that** none of said small non ink-accepting surfaces of said second group is in contact with a small non ink-accepting surface of said first group.

10. The plate according to any one of claims 1 to 9, **characterized in that** each of said small non ink-accepting surfaces of said first and second groups is inside the ink-accepting surface within which it is present.

11. The plate according to any one of claims 1 to 10, **characterized in that** said small non ink-accepting surfaces of said first group have the same area and/or, advantageously and, said small non ink-accepting surfaces of said second group have the same area.

12. A process for preparing a plate according to any one of claims 1 to 11,
**characterized in that** it comprises copying said plate to generate the ink-accepting surfaces corresponding to the patterns to be printed on the surface of said plate as well as said small non ink-accepting lightening surfaces within said ink-accepting surfaces; said small non ink-accepting surfaces being copied:
· by a technique for exposing said plate through at least one film and/or a technique for exposing a precursor web of positive pre-sensitized plates through the opaque wall of a tube; and/or
· by a technique for directly exposing said plate with beams controlled by software; and/or
· by a projection technique.

13. A wet offset printing process, comprising:
· copying a plate, generating ink-accepting surfaces on the surface of said plate corresponding to the patterns to be printed and including small non ink-accepting lightening surfaces;
· fixing said copied plate to a plate cylinder;
· wetting then inking said fixed copied plate or inking it directly with an ink based on an ink/water mixture; and
· transferring the ink held on said lightened ink-accepting surfaces onto the blanket then onto the substrate to be printed in succession;
**characterized in that** the copy of said plate generates a plate according to any one of claims 1 to 11.

## Patentansprüche

1. Für den Naß-Offsetdruck verwendbare Platte, die an ihrer Oberfläche farbannehmende Flächen aufweist, welche den zu druckenden Motiven entsprechen,
wobei wenigstens ein Teil der farbannehmenden Flächen erleichtert ist, d.h. kleine, nicht-farbannehmende Entlastungsflächen einschließt, **dadurch gekennzeichnet, daß** sich die kleinen, nicht-farbannehmenden Entlastungsflächen - in wenigstens einem Teil der erleichterten farbannehmenden Flächen - auf wenigstens zwei Gruppen verteilen:
- eine erste Gruppe von kleinen, nicht-farbannehmenden Flächen mit ausreichender (ausreichenden) Oberfläche(n), um per se wirkungsvoll zu sein, und in einer ausreichenden Menge, um die von der Entlastung betroffene(n) farbannehmende(n) Fläche(n) um wenigstens 4 % zu erleichtern; und
- eine zweite Gruppe von kleinen, nicht-farbannehmenden Flächen, die aufgrund ihrer zu kleinen Oberfläche(n) nicht per se wirkungsvoll sind, wobei die durchschnittliche Oberfläche der kleinen, nicht-farbannehmenden Flächen der zweiten Gruppe im allgemeinen kleiner als 2/3 der durchschnittlichen Oberfläche der kleinen, nicht-farbannehmenden Flächen der ersten Gruppe ist;
wobei die kleinen, nicht-farbannehmenden Flächen der ersten und der zweiten Gruppe derart verteilt sind, daß jedweder Moiré-Effekt reduziert, vorteilhafterweise vermieden wird.

2. Platte nach Anspruch 1, **dadurch gekennzeichnet, daß** die kleinen, nicht-farbannehmenden Flächen der ersten und/oder der zweiten Gruppe zufällig oder entsprechend herkömmlicher Raster und dann, für jede Farbe, entsprechend der für den Raster der Farbe verwendeten Ausrichtung verteilt sind.

3. Platte nach Anspruch 1 oder 2, **dadurch gekennzeichnet, daß** - für einen Druck der Motive mit einem stochastischen Raster - die kleinen, nicht-farbannehmenden Flächen der ersten und der zweiten Gruppe, die entsprechend einem herkömmlichen Raster (herkömmlichen Rastern) verteilt sind, für jede Farbe entsprechend der normalerweise für den Druck der Farbe verwendeten Ausrichtung ausgerichtet sind.

4. Platte nach einem der Ansprüche 1 bis 3, **dadurch gekennzeichnet, daß** die durchschnittliche Oberfläche der kleinen, nicht-farbannehmenden Flächen der zweiten Gruppe zwischen 1/4 und 2/3, vorteilhafterweise zwischen 1/4 und der Hälfte der durchschnittlichen Oberfläche der kleinen, nicht-farbannehmenden Flächen der ersten Gruppe beträgt.

5. Platte nach einem der Ansprüche 1 bis 4, **dadurch gekennzeichnet, daß**:
- für einen Druck der Motive mit einem amplitudenmodulierten Raster die Oberfläche(n) der kleinen, nicht-farbannehmenden Flächen der ersten Gruppe geringer als der Weißpunkt des Wertes 95 % und vorteilhafterweise des Wertes 98 % des Rasters bleibt (bleiben), oder
- für einen Druck der Motive mit einem stochastischen Raster die Oberfläche(n) der kleinen, nicht-farbannehmenden Flächen der ersten Gruppe kleiner als das Dreifache der Oberfläche des Punktes des Rasters bleibt (bleiben), im allgemeinen zwischen der Hälfte und dem Zweifachen der genannten Oberfläche beträgt (betragen).

6. Platte nach einem der Ansprüche 1 bis 5, **dadurch gekennzeichnet, daß** die kleinen, nicht-farbannehmenden Flächen der ersten Gruppe in einer ausreichenden Menge vorkommen, um die von der Entlastung betroffene(n) farbannehmende(n) Fläche(n) um 4 bis 20 %, vorteilhafterweise um 6 bis 12 % zu erleichtern.

7. Platte nach einem der Ansprüche 1 bis 6, **dadurch gekennzeichnet, daß** die kleinen, nicht-farbannehmenden Flächen der zweiten Gruppe in einer ausreichenden Menge vorkommen, um die von der Entlastung betroffene(n) farbannehmende(n) Fläche(n) um 4 bis 35 %, vorteilhafterweise um 8 bis 20 % zu erleichtern.

8. Platte nach einem der Ansprüche 1 bis 7, **dadurch gekennzeichnet, daß** der Entlastungsgrad ihrer farbannehmenden Flächen nicht konstant ist.

9. Platte nach einem der Ansprüche 1 bis 8, **dadurch gekennzeichnet, daß** keine der kleinen, nicht-farbannehmenden Flächen der zweiten Gruppe mit einer kleinen, nicht-farbannehmenden Fläche der ersten Gruppe in Kontakt ist.

10. Platte nach einem der Ansprüche 1 bis 9, **dadurch gekennzeichnet, daß** eine jede der kleinen, nicht-farbannehmenden Flächen der ersten und der zweiten Gruppe in der farbannehmenden Fläche ist, innerhalb derer sie zum Einsatz kommt.

11. Platte nach einem der Ansprüche 1 bis 10, **dadurch gekennzeichnet, daß** die kleinen, nicht-farbannehmenden Flächen der ersten Gruppe die gleiche Oberfläche haben und/oder, vorteilhafterweise und, die kleinen, nicht-farbannehmenden Flächen der zweiten Gruppe die gleiche Oberfläche aufweisen.

12. Verfahren zum Herstellen einer Platte nach einem der Ansprüche 1 bis 11, **dadurch gekennzeichnet, daß** es das Kopieren der Platte umfaßt, um an der Oberfläche der Platte die den zu druckenden Motiven entsprechenden farbannehmenden Flächen sowie die kleinen, nicht-farbannehmenden Entlastungsflächen innerhalb der farbannehmenden Flächen zu erzeugen, wobei die kleinen, nicht-farbannehmenden Entlastungsflächen wie folgt kopiert werden:
- mittels einer Technik zum Belichten der Platte durch wenigstens einen Film hindurch und/oder einer Technik zum Belichten eines Vorläuferbandes vorsensibilisierter Positivplatten durch die opake Wand einer Röhre hindurch, und/oder
- mittels einer Technik zum direkten Belichten der Platte mit durch Software gesteuerten Strahlen, und/oder
- durch eine Spritztechnik.

13. Naß-Offsetdruck-Verfahren, das folgendes umfaßt:
- das Kopieren einer Platte, das an der Oberfläche der Platte farbannehmende Flächen erzeugt, die den zu druckenden Motiven entsprechen und kleine, nicht-farbannehmende Entlastungsflächen einschließen,
- das Befestigen der kopierten Platte an einem Plattenzylinder,
- das Befeuchten, anschließend das Einfärben der befestigten kopierten Platte oder direkt deren Einfärben mit einer Farbe auf Grundlage eines Farbe/Wasser-Gemischs,
- das Übertragen der auf den erleichterten farbannehmenden Flächen gehaltenen Farbe nacheinander auf das Gummituch, anschließend auf den Bedruckstoff,
**dadurch gekennzeichnet, daß** das Kopieren der Platte eine Platte nach einem der Ansprüche 1 bis 11 hervorbringt.
